# EUROPÄISCHE PATENTSCHRIFT

(11) **EP 0 326 098 B1**
(45) Veröffentlichungstag und Bekanntmachung des Hinweises auf die Patenterteilung: **11.08.1993**
(21) Anmeldenummer: 89101261.9
(22) Anmeldetag: 25.01.1989
(51) Int. Cl.: G01R 1/04

(54) **Prüfeinrichtung mit einer Kontaktiervorrichtung und mindestens einem Prüfling**
Testing device comprising a contacting device and at least one test specimen
Dispositif de test comprenant un contacteur et au moins un échantillon de test

(30) Priorität: 27.01.1988 DE 3802304
(43) Veröffentlichungstag der Anmeldung: 02.08.1989
(73) Patentinhaber: Prokopp, Manfred, 97877 Wertheim (DE)
(72) Erfinder: Prokopp, Manfred, D-6980 Wertheim (DE); Kaufmann, Herbert, CH-6330 Cham (CH)
(74) Vertreter: Grosse, Rainer, Dipl.-Ing.

(56) Entgegenhaltungen:
- DE-B- 2 613 858
- GB-A- 2 113 480
- US-A- 4 626 780

## Beschreibung

Die Erfindung betrifft eine Prüfeinrichtung mit einer Kontaktiervorrichtung und mindestens einem Prüfling gemäß dem Oberbegriff des Anspruchs 1.

Der Prüfling weist eine Leiterplatte oder einen Verdrahtungen tragenden Verdrahtungsträger mit meist einer großen Anzahl Messerleisten und/oder Buchsenleisten auf, bspw. mit zehn bis mehreren hundert solcher Leisten. Die Messerleisten und Buchsenleisten solcher Prüflinge haben normalerweise relativ große Anzahlen von Messern oder Buchsen, bspw. pro Leiste eine Reihe oder mehrere zueinander parallele Reihen mit je 32 oder auch mehr oder weniger Messern oder Buchsen pro Reihe. Bei den Messern handelt es sich um im allgemeinen gerade starre metallische Stifte rechteckförmigen Querschnittes, die an ihren freien Enden angespitzt sind. Diese Messerleisten kann man auch als Steckerleisten bezeichnen. Die bekannten Prüfeinrichtungen zum Prüfen solcher Prüflinge weisen als Kontaktiervorrichtung eine der Anzahl der Messerleisten bzw. Buchsenleisten des Prüflinges entsprechende Anzahl von zu ihnen komplementären Buchsenleisten bzw. Messerleisten auf, von denen jede nur am Ende eines flexiblen Kabels gehalten war, das die elektrischen Verbindungen zwischen ihr und einem Testgerät der Prüfeinrichtung herstellte. Dabei wurden bisher, um einen Prüfling zu prüfen, alle an das Testgerät ständig angeschlossenen komplementären Messerleisten und Buchsenleisten auf die zugeordneten Buchsenleisten und Messerleisten des Prüflings manuell einzeln nacheinander von einer Person aufgesteckt, was viel Zeit und Kraft benötigt. Nachdem alle Messerleisten und Buchsenleisten des Prüflings auf diese Weise an das Testgerät angeschlossen waren, wurde der Prüfling auf elektrische Fehlerfreiheit geprüft. Dann mußten anschließend die komplementären aufgesteckten Buchsenleisten und Messerleisten der Prüfeinrichtung wieder einzeln nacheinander von Hand vom Prüfling abgenommen werden, was den Prüfling unerwünscht erheblich auf Zug beansprucht und wieder viel Zeit benötigt. Auch war es schwierig, wenn das Testgerät einen bestimmten Fehler des Prüflings oder seiner Kontaktierung anzeigte, sich Zugang zur betreffenden Stelle des noch eingespannten Prüflings zur Behebung des Fehlers zu verschaffen.

Aus der britischen Patentanmeldung GB-A-2 113 480 geht eine Kontaktiervorrichtung hervor, die pneumatisch mittels einer Kolben/Zylinder-Einheit betrieben wird. Der Prüfling wird in definierter Position befestigt. Anschließend bewegt die Kolben/Zylinder-Einheit einen Schlitten, so daß Federkontaktstifte, die Prüfkontakte bilden, mit Kontakten des Prüflings in Verbindung treten. Dabei wird eine dem jeweiligen Federkontaktstift zugeordnete Schraubendruckfeder gespannt. Um die Kontaktierung wieder aufzuheben, wird der Schlitten in die entgegengesetzte Richtung verfahren. Dabei entspannen sich die Schraubendruckfedern, so daß der Kontaktdruck aufgehoben wird. Der Kontakt zwischen den Federkontaktstiften und den Kontakten des Prüflings wird durch Gegeneinandertreten der entsprechenden Kontaktanordnungen hergestellt. Beim Lösen dieser Kontaktverbindungen entstehen daher keine Kontakt-Abzugskräfte.

Der Erfindung liegt die Aufgabe zugrunde, eine Prüfeinrichtung der eingangs genannten Art zu schaffen, mit der ein elektrischer Anschluß des jeweiligen Prüflings und sein elektrisches Trennen rasch und einfach durchführbar ist.

Diese Aufgabe wird erfindungsgemäß mit der Prüfeinrichtung gemäß Anspruch 1 gelöst.

Diese Prüfeinrichtung läßt raschen und einfachen gleichzeitigen Anschluß aller Buchsen- und Messerleisten des jeweiligen Prüflings an die Prüfeinrichtung und gleichzeitiges rasches Wiederlösen dieser elektrischen Verbindungen zu. Dies kann motorisch voll- oder halbautomatisch erfolgen, so daß hierfür keine Bedienungsperson mehr benötigt wird oder sie stark entlastet ist. Bei Prüflingen mit nur wenigen Messerleisten und/oder Buchsenleisten kann auch vorgesehen sein, daß die Bedienungsperson vorzugsweise über eine Vorrichtung mit einer kraftmindernden Übertragung, bspw. einem hydraulischen Getriebe, das Zusammenführen und Wiedertrennen der Messerleisten und/oder Buchsenleisten des Prüflings von den Prüfkontakten der Prüfeinrichtung manuell vornimmt. Die elektrischen Kontaktverbindungen zwischen den Messerleisten und /oder Buchsenleisten des Prüflings und den Prüfkontakten sind als Steckverbindungen ausgebildet. Steckverbindungen haben unter anderem folgende Vorteile. Sie können den späteren Steckverbindungen entsprechen, mit denen der geprüfte Prüfling an ein elektrisches Gerät angeschlossen wird und es können so Fehler bei der Prüfung entdeckt werden, die sonst unentdeckt geblieben wären, beispielsweise schadhafte Buchsen oder Messer. Steckverbindungen ergeben besonders gute Kontakte. Die Prüfkontakte können die Buchsen und Messer handelsüblicher Buchsenleisten beziehungsweise Messerleisten sein, die allenfalls nur relativ geringe Nacharbeiten benötigen.

Die Rückstellfedern haben eine sehr wichtige Aufgabe, nämlich das Ablösen der Prüfkontakte von den Messerleisten und/oder Buchsenleisten des Prüflings selbst dann problemlos und ohne Beschädigungsgefahr für den Prüfling zu ermöglichen, wenn das gleichzeitige Abziehen der Prüfkontakte aus den Buchsen und gegebenenfalls von den Messern des Prüflings extrem große Kraft benötigt. Auch ermöglicht dies, daß die Leiterplatte oder dergleichen des Prüflings selbst weniger starr ausgeführt werden muß und sich so deren Bauart besonders einfach gestalten läßt.

Vorzugsweise können die Rückstellfedermittel so stark sein, daß sie allein das Ablösen der Prüfkontakte von den Messerleisten und/oder Buchsenleisten des Prüflings bewirken, so daß der motorische Antrieb oder die Bedienungsperson, der beziehungsweise die dies vornimmt, beim Abnehmen der Prüfkontakte von den Messerleisten und/oder Buchsenleisten des Prüflings keine Zugkraft auf die Tragvorrichtung und den Prüfling ausüben müssen, da die Rückstellfedermittel das Lösen der elektrischen Kontaktverbindungen zwischen den Prüfkontakten und dem Prüfling dann allein bewirken können und es für dieses Lösen nur erforderlich ist, daß der Abstand zwischen der Tragvorrichtung und dem Prüfling durch den Antrieb oder die Bedienperson nach Beendigung der Prüfung vergrößert wird.

Die Tragvorrichtung kann beispielsweise zweckmäßig eine relativ dünne Platte aufweisen, an der die Prüfkontakte angeordnet werden und die ebenfalls problemlos gegen Druckkräfte abgestützt werden kann.

Die Rückstellfedern können vorzugsweise an den Prüfkontakten angeordnet sein. Dies ist für das Lösen der Verbindungen zwischen den Prüfkontakten und den Messerleisten und/oder Buchsenleisten des Prüflings besonders günstig, da dann Rückstellfedern und/oder mindestens ein von ihnen belastetes Teil der Kontaktiervorrichtung sich direkt an den durch Prüfkontakte zu kontaktierenden Messerleisten und/oder Buchsenleisten des jeweiligen Prüflings abstützen können und so das Wiederlösen der elektrischen Verbindungen zwischen dem Prüfling und den Prüfkontakten besonders schonend für den Prüfling vor sich gehen kann.

Es ist jedoch auch möglich, alle Rückstellfedern oder zumindest eine von ihnen abseits der Prüfkontakte anzuordnen, beispielsweise eine mehr oder weniger große Anzahl von Rückstellfedern zwischen Prüfkontakten und/oder seitlich von ihnen so über die Tragvorrichtung zu verteilen, daß die Ruckstellfedern und/oder mindestens ein von ihnen belastetes bewegliches Teil der Kontaktiervorrichtung am jeweiligen Prüfling an Stellen angreifen, wo dies zulässig ist, also insbesondere abseits von elektrischen Leiterbahnen, elektrischen Kontakten und sonstigen Stellen des Prüflings, die von den Federn nicht kontaktiert werden dürfen.

Besonders zweckmäßig ist es, vorzusehen, daß mindestens eine Rückstellfeder der Rückstellfedermittel mindestens ein beweglich gelagertes, vorzugsweise geradegeführtes Druckteil federbelastet, das durch die ihm zugeordnete mindestens eine Rückstellfeder beim Kontaktieren eines Prüflings an die zu kontaktierende Stelle oder Stellen, vorzugsweise mindestens eine Messerleiste und/oder Buchsenleiste des Prüflings andrückbar ist. Bevorzugt kann das Druckteil an der Kontaktiervorrichtung geradegeführt und/oder so ausgebildet sein, daß es an Vorsprüngen oder Absätzen oder der Stirnseite einer Messerleiste und/oder Buchsenleiste des jeweiligen Prüflings, vorzugsweise ungefähr über die Länge der Messerleiste und/oder Buchsenleiste zur Auflage kommen kann. Solche Druckteile können vorzugsweise gleich oder ähnlich wie die Kunststoffteile von Messerleisten und/oder Buchsenleisten von Prüflingen ausgebildet sein, derart, daß das Druckteil, welches zum Inkontaktkommen mit einer Messerleiste von Prüflingen bestimmt ist, gleich oder ähnlich dem Kunststoffteil einer zu dieser Messerleiste komplementären Buchsenleiste ist und/oder daß im Falle einer Buchsenleiste eines Prüflings das Druckteil der Kontaktiervorrichtung, das zum Inkontaktkommen mit dieser Buchsenleiste bestimmt ist, gleich oder ähnlich dem Kunststoffteil einer zu dieser Buchsenleiste komplementären Messerleiste ist. Damit läßt sich auch erreichen, wenn die Prüfkontakte gleichzeitig wie Messer bzw. Buchsen von Messerleisten bzw. Buchsenleisten des Prüflings ausgebildet sind oder solche Messer bzw. Buchsen bilden, daß das Kontaktieren der Messerleisten und/oder Buchsenleisten des Prüflings durch die Kontaktiervorrichtung praktisch exakt so erfolgt, wie es beim späteren Anschluß des Prüflings an elektronische oder elektrische Geräte durch an seine Messerleisten und/oder Buchsenleisten ansteckbare komplementäre Buchsenleisten und/oder Messerleisten erfolgt. Auch verbilligt dies die Herstellung der Kontaktiervorrichtung, da handelsübliche Kunststoffteile solcher Messerleisten und/oder Buchsenleisten und/oder solche Messerleisten und/oder Buchsenleisten ohne oder mit nur geringer nachträglicher Änderung für diese Druckteile verwendet werden können.

Die Prüfkontakte, die dem Kontaktieren der Messer und Buchsen der Messerleisten und Buchsenleisten des jeweiligen Prüflings dienen, sind an einer Tragvorrichtung angeordnet, und es kann vorzugsweise mindestens ein Stellmotor vorgesehen sein, der die von dieser Tragvorrichtung getragenen Prüfkontakte mit dem jeweiligen Prüfling ohne Mitwirkung menschlicher Kraft in Kontakt bringt zur selbsttätigen Herstellung der elektrischen Verbindungen zwischen den Buchsenleisten und Messerleisten des Prüflinges und den Prüfkontakten der Kontaktriervorrichtung. An dieser Tragvorrichtung können auch noch andere Prüfkontakte angeordnet sein, die dem Kontaktieren sonstiger Stellen des jeweiligen Prüflings dienen, bspw. Leiterbahnen und dgl..

In vielen Fällen hat der Prüfling nur auf einer seiner beiden Seiten zu kontaktierende Messerleisten und/oder Buchsenleisten und es ist dann ausreichend, wenn die Kontaktiervorrichtung eine einzige solche Tragvorrichtung mit Prüfkontakten aufweist. Wenn dagegen, was auch oft der Fall ist, der Prüfling auf seinen beiden Seiten Messerleisten und/oder Buchsenleisten trägt, die alle gemeinsam in elektrische Verbindung mit dem Testgerät für die Prüfung des Prüflings gebracht werden müssen, dann kann die Kontaktiervorrichtung für jede der beiden Seiten des Prüflings jeweils eine Tragvorrichtung mit Prüfkontakten zum Kontaktieren der betreffenden Messerleisten bzw. Buchsenleisten des Prüflings aufweisen. In diesem Fall kann bspw. vorgesehen sein, daß der Prüfling fest eingespannt wird und die beiden Tragvorrichtungen gleichzeitig auf die beiden Seiten des Prüflinges zum Inkontaktkommen der Prüfkontakte mit den zu kontaktierenden Messerleisten und/oder Buchsenleisten zu und nach der Prüfung wieder von ihm weg bewegt werden. Oder man kann bei zwei Tragvorrichtungen bspw. vorsehen, eine von ihnen ortsfest anzuordnen, dann den Prüfling vorzugsweise motorisch zu ihr zu bewegen, bis die elektrischen Verbindungen zwischen den Prüfkontakten und den Messerleisten und/oder Buchsenleisten auf der betreffenden Seite des Prüflings hergestellt sind und dann die andere Tragvorrichtung zu der anderen Seite des Prüflings vorzugsweise motorisch zu bewegen bis auch hier die erforderlichen elektrischen Verbindungen zwischen den Prüfkontakten und den von ihnen zu kontaktierenden Messerleisten und/oder Buchsenleisten auf der betreffenden Seite des Prüflings hergestellt sind. Das Wiedertrennen der elektrischen Verbindungen kann dann in umgekehrter Reihenfolge erfolgen.

Wenn nur eine Tragvorrichtung vorgesehen ist, dann kann sie oder der jeweilige Prüfling ortsfest gehalten sein und der Prüfling bzw. sie vorzugsweise motorisch bewegt werden, bspw. auf einem Schlitten oder an einem Hebelsystem angeordnet sein, bis die elektrischen Verbindungen zwischen ihren Prüfkontakten und den durch sie zu kontaktierenden Messerleisten und/oder Buchsenleisten des Prüflings hergestellt sind.

Das elektrische Verbinden der Prüfkontakte einer Tragvorrichtung mit den Messern und Buchsen aller Messerleisten und/oder Buchsenleisten des jeweiligen Prüflings ist problemlos mit den erforderlichen oft extrem großen Kräften durchführbar, weil beim Zusammenführen von Prüfkontakten und Prüfling der Prüfling und die Tragvorrichtung durch die Prüfkontakte nur auf Druck und nicht auf Zug beansprucht zu werden brauchen, und die Abstützung des oder der die Prüfkontakte haltenden oder sie unmittelbar tragenden Teile und des jeweiligen Prüflings gegen Druck problemlos möglich ist, so daß die Prüfkontakte und der Prüfling mit ausreichend großer Kraft problemlos zusammengeführt werden können, bis die Prüfkontakte in sicheren elektrischen Kontakt mit den von ihnen zu kontaktierenden Buchsen und/oder Messern der betreffenden Buchsen und/oder Messerleisten des Prüflings gekommen sind. Die Rückstellfedermittel, die bereits vorgespannt sein können oder auch nicht, werden dabei weitergespannt oder gespannt und bewirken nun, wenn diese elektrischen Verbindungen zwischen den Prüfkontakten und den Messer- und/oder Buchsenleisten des Prüflings wieder zu lösen sind, daß dies problemlos gelingt, indem sie die hierfür erforderliche Kraft zumindest zum Teil, vorzugsweise vollständig ausüben, was insbesondere dann von größter Bedeutung ist, wenn die Kontaktverbindungen zwischen den Buchsen und/oder Messern des jeweiligen Prüflinges und den Prüfkontakten Steckverbindungen sind, die bei ihrer Herstellung und ihrem Wiederlösen erhebliche Kräfte zur Überwindung der Reibungskräfte dieser Steckverbindungen benötigen. In letzterem Fall werden dann Träger und Prüfling auch beim Abnehmen der Prüfkontakte vom Prüfling nur auf Druck und nicht auf Zug beansprucht, was äußerst vorteilhaft ist.

Besonders zweckmäßig ist es, vorzusehen, daß zumindest einige, vorzugsweise alle dem Kontaktieren der Buchsen der Buchsenleisten dienenden Prüfkontakte axial starre Stifte (Starrstifte) sind, vorzugsweise Messer von Messerleisten. Diese Messerleisten können in diesem Falle dieselben Kunststoffteile aufweisen, wie die Messerleisten des Prüflinges, wobei jedoch die Messer der Messerleisten an der Kontaktiervorrichtung vorzugsweise länger sein können als die Messer der Messerleisten am Prüfling. Auf diese Messer der Messerleisten an der Kontaktiervorrichtung können dann vorzugsweise Druckteile aus Kunststoff aufgesetzt sein, die für jedes Messer ein eigenes Loch aufweisen, das von dem betreffenden Messer mit Gleitlagerspiel durchdrungen ist. Die als Prüfkontakte dienenden Messer können vorzugsweise ebenfalls rechteckförmige Querschnitte aufweisen und an ihren freien Enden angespitzt sein. Es ist jedoch auch möglich, sie anders auszubilden, bspw. als kreiszylindrische Stifte mit angespitzten freien Enden oder dgl..

In vielen Fällen ist es vorteilhaft, vorzusehen, daß zumindest einige, vorzugsweise alle dem Kontaktieren von Messern von Messerleisten und/oder Buchsen von Buchsenleisten von Prüflingen dienenden Prüfkontakte Federkontaktstifte sind. Federkontaktstifte sind an sich bekannt, doch wurden sie bisher nicht zum Kontaktieren von Messerleisten und Buchsenleisten von Prüflingen eingesetzt. Ein Federkontaktstift weist ein geradegeführtes gleitgelagertes Kolbenglied auf, das durch mindestens eine Schraubenfeder in Richtung auf den Prüfling zu belastbar oder belastet ist. Die Schraubenfeder stützt sich an einem relativ zu einem Träger unbeweglichen Anschlag, bspw. am Träger selbst ab. Bevorzugt kann der Federkontaktstift jedoch so ausgebildet sein, daß sein Kolbenglied in einer Hülse gleitbar gelagert ist, in der auch die mindestens eine ihn belastende, eine Rückstellfeder bildende Schraubendruckfeder angeordnet ist.

Das dem Prüfling zugewendete Stirnende des vorzugsweise axial starren Kolbengliedes des Federkontaktstiftes dient dem Kontaktieren eines Messers oder einer Buchse des jeweiligen Prüflings.

Federkontaktstifte haben, wenn sie dem Kontaktieren von Messern von Prüflingen dienen, gegenüber Starrstiften als Prüfkontakte den Vorteil, daß die Rückstellfedern schwächer ausgebildet sein können, da das Kontaktieren eines Messers eines Prüflinges nicht unter Aufstecken einer Buchse auf es erfolgen muß, so daß das Kontaktieren ohne axiale Reibung zwischen Messer und Kontaktkolben erfolgen kann und so auch praktisch reibungsfreies Lösen dieser Verbindung wieder möglich ist und die Rückstellfeder dient insbesondere der Herbeiführung sicheren elektrischen Kontaktes zwischen Kolbenglied und Messer.

In vielen Fällen ist es besonders zweckmäßig, vorzusehen, daß die dem Kontaktieren der Messer mindestens einer Messerleiste eines Prüflings dienenden Prüfkontakte Buchsen mindestens einer Buchsenleiste sind, die eine zu einer von ihr elektrischen zu kontaktierenden Messerleiste eines Prüflinges komplementäre Buchsenleiste ist. Die einzelne Buchsenleiste, die also an der Tragvorrichtung angeordnet ist, kann dabei in vielen Fällen zweckmäßig durch Rückstellfedermittel belastet an ihr beweglich angeordnet sein, vorzugsweise geradegeführt sein, und ähnlich oder gleich wie Buchsenleisten der Prüflinge ausgebildet sein, mit dem Unterschied, daß an ihrem Kunststoffteil noch Maßnahmen für ihre bewegliche Führung vorgesehen sind. Oder es kann in vielen Fällen besonders zweckmäßig vorgesehen sein, die Buchsenleisten an der Tragvorrichtung der Kontaktiervorrichtung fest anzuordnen und vorzugsweise ihr ein an der Tragvorrichtung beweglich angeordnetes und durch Rückstellfedern belastetes Druckteil zuzuordnen, das beim Kontaktieren einem Messerleiste eines Prüflinges durch diese Messerleiste gegen die Wirkung der Rückstellfedern in Richtung auf die Tragvorrichtung zu unter Spannen oder weiterem Spannen der Rückstellfedern zurückgeschoben wird und das dann nach Beendigung der Prüfung des jeweiligen Prüflinges, wenn die Tragvorrichtung und der Prüfling wieder relativ voneinander weggeführt werden, dann die dem Abziehen der an der Tragvorrichtung fest angeordneten Buchsenleiste von der betreffenden Messerleiste des jeweiligen Prüflings dienende Kraft infolge seiner Federbelastung zumindest zu einem erheblichen Teil, vorzugsweise allein ausüben kann.

Bevorzugt können die Prüfkontakte in an der Tragvorrichtung vorzugsweise lösbar angeordneten Baueinheiten angeordnet sein, wobei jede Baueinheit zum Kontaktieren aller Messer oder Buchsen einer Messer- oder Buchsenleiste des jeweiligen Prüflinges ausgebildet ist.

Dies hat u.a. den Vorteil, daß diese Baueinheiten besonders einfache Anpassung der Kontaktiervorrichtung an die Prüflinge ermöglicht und sie auch für andere Anordnungen wiederverwendet werden können.

Die Tragvorrichtung kann irgendeine ein- oder mehrteilige Ausbildung aufweisen. So kann sie oft vorteilhaft einen oder mehrere Träger, vorzugsweise eine oder mehrere Platten aufweisen, an der oder denen die Prüfkontakte angeordnet sind.

Da vorzugsweise die Tragvorrichtung durch das Herstellen und Lösen der Kontaktverbindungen zwischen Prüfling und Prüfkontakten nicht auf Zug oder nur relativ unbedeutend auf Zug beansprucht wird, ist es zumindest in diesem Fall auch nicht nötig, die Prüfkontakte an der Tragvorrichtung so anzuordnen, daß auf sie Zugkräfte oder erhebliche Zugkräfte ohne ihre Lage relativ zu der Tragvorrichtung hierdurch zu ändern, ausgeübt werden können. Dies ermöglicht, sie mittels ihrem elektrischen Anschluß dienenden Steckverbindungen an an der Tragvorrichtung angeordneten Anschlußteilen, vorzugsweise an Buchsenleisten und/oder Messerleisten nur formschlüssig und reibschlüssig lösbar zu halten, vorzugsweise nur durch die den elektrischen Verbindungen dienenden Steckverbindungen zwischen diesen Teilen, wobei diese Anschlußteile ebenfalls mittels ihrem elektrischen Anschluß dienenden Steckverbindungen an der Tragvorrichtung lösbar formschlüssig und reibungsschlüssig gehalten sein können, vorzugsweise derart, daß zum Tragen und zum elektrischen Anschluß einer eine Baueinheit bildende Prüfkontaktgruppe auf einem Träger, vorzugsweise einer Platte, ein Anschlußteil für sie angeordnet ist, das mittels seinem elektrischen Anschluß dienenden Anschlußstiften den Träger durchdringt und auf diese Anschlußstifte eine dieses Anschlußteil an dem Träger haltendes anderes Anschlußteil, vorzugsweise eine Buchsenleiste, formschlüssig und reibungsschlüssig aufgesteckt ist. Es bedarf dann keiner zusätzlichen Befestigung dieser Anschlußteile an dem Träger, sondern nur ihrem Zusammenstecken, wobei die genaue Position dieser Anschlußteile durch die Positionierung von mindestens zwei der die Platte durchdringenden Anschlußstiften in sie formschlüssig aufnehmenden Löchern des Trägers zweckmäßig vornehmbar ist.

In der Zeichnung sind Ausführungsbeispiele der Erfindung dargestellt. Es zeigen:
- Fig. 1: eine Seitenansicht einer Prüfeinrichtung mit einer Kontaktiervorrichtung gemäß einem Ausführungsbeispiel der Erfindung in die ein Prüfling eingesetzt ist, wobei von dem dargestellten Prüfling nur eine Messerleiste und Buchsenleiste zu sehen ist, jedoch weist er normalerweise eine große Anzahl von Messerleisten und/oder Buchsenleisten auf, die durch an der Kontaktiervorrichtung angeordnete Prüfkontakte gleichzeitig kontaktierbar sind,
- Fig. 2: eine gebrochene und teilweise geschnittene Seitenansicht der einen eine Baueinheit bildende Prüfkontaktgruppe der Fig. 1, die dem Kontaktieren einer Messerleiste des in Fig. 1 dargestellten Prüflings dient,
- Fig. 3: eine stirnseitige Ansicht der Prüfkontaktgruppe nach Fig. 2,
- Fig. 4: eine Draufsicht auf die Prüfkontaktgruppe nach Fig. 2 und 3,
- Fig. 5: eine teilweise geschnittene und gebrochene Seitenansicht der ebenfalls eine Baueinheit bildende Prüfkontaktgruppe der Fig. 1, die dem Kontaktieren einer Buchsenleiste des Prüflinges in Fig. 1 dient,
- Fig. 6: eine teilweise geschnittene, stirnseitige Ansicht der Prüfkontaktgruppe nach Fig. 5,
- Fig. 7: eine gebrochene Draufsicht auf die Prüfkontaktgruppe nach Fig. 5 und 6,
- Fig. 8: eine Seitenansicht einer eine Baueinheit bildenden Prüfkontaktgruppe gemäß einem weiteren Ausführungsbeispiel, die dem Kontaktieren einer Messerleiste eines Prüflinges dient, in teilweise geschnittener und gebrochener Darstellung,
- Fig. 9: eine Draufsicht auf die Prüfkontaktgruppe nach Fig. 8,
- Fig. 10: eine Variante der Fig. 3,
- Fig. 11: eine Variante der Fig. 1.

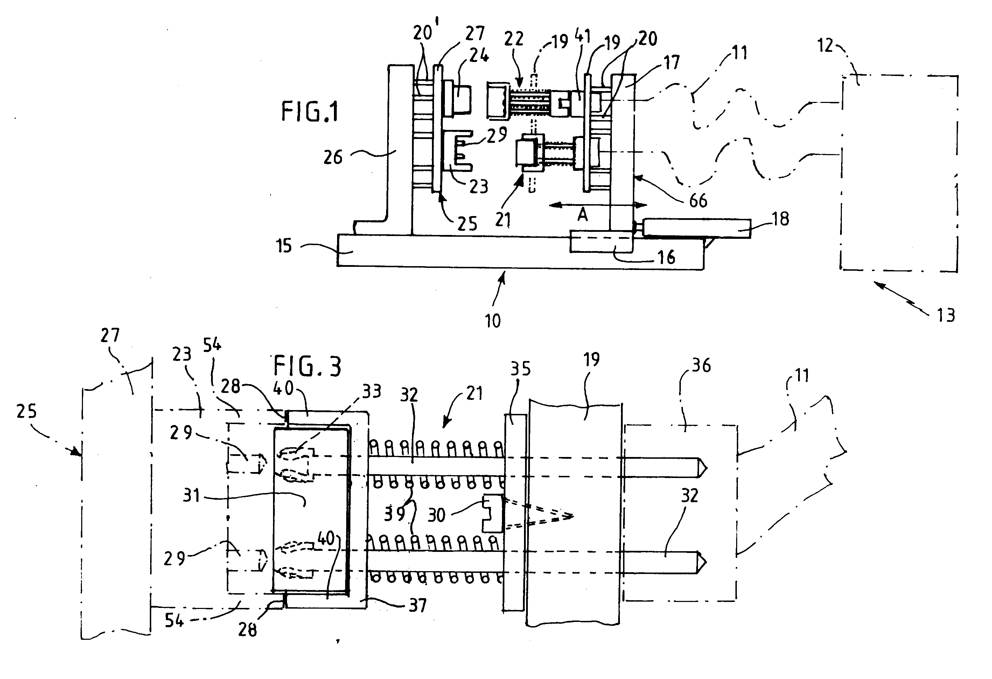

Die in Fig. 1 dargestellte Kontaktiervorrichtung 10 ist über strichpunktiert angedeutete flexible Kabel 11 an ein strichpunktiert angedeutetes Testgerät 12 angeschlossen und bildet zusammen mit diesem Testgerät 12 eine Prüfeinrichtung 13 zum Prüfen von eine Mehrzahl, vorzugsweise sehr viele Messerleisten und/oder Buchsenleisten aufweisenden Prüflingen. Jeder zu prüfende Prüfling 25 wird an einer unbeweglichen Haltevorrichtung 26 gehalten, die an einem Gestell 15 befestigt ist. Es genügt zumindest in vielen Fällen, den Prüfling nur in vorbestimmter Stellung an die Haltevorrichtung 26,20' anzulehnen, bspw. dann, wenn er an der Haltevorrichtung nicht vertikal angeordnet wird, sondern bspw. horizontal oder schräg angeordnet wird, damit er nicht umfallen kann, vorausgesetzt, daß er bei der Herstellung und dem Wiederlösen der Kontaktverbindungen zwischen den Prüfkontakten und dem Prüfling nicht auf Zug beansprucht wird, wie es besonders vorteilhaft ist. Das Gestell 15 der Kontaktiervorrichtung 10 ist ortsfest angeordnet und an ihm ist ein Schlitten 16 horizontal geradegeführt angeordnet, der durch eine hydraulische oder pneumatische Kolben-Zylinder-Einheit 18, die als Stellmotor dient, in Richtung des Doppelpfeiles A horizontal hin- und herbewegbar ist.

Auf dem Schlitten 16 ist eine Platten 17 und 19 und Pfosten 20 aufweisende starre Tragvorrichtung 66 fest angeordnet. Die Platte 17 ist am Schlitten 16 vertikal befestigt und an ihr ist die vertikale Tragplatte 19 lösbar gehalten und rückseitig an vielen Punkten mittels den starren Pfosten 20 der Tragvorrichtung 66 gegen vorderseitige Druckbelastung abgestützt. Diese Pfosten 20 liegen an der Tragplatte 19 an Stellen an, wo keine elektrischen Kontakte vorhanden sind. Die Tragplatte 19 kann bspw. aus elektrisch isolierendem Kunststoff, wie Plexiglas oder dgl. bestehen. An ihr sind eine Mehrzahl je eine Baueinheit bildende Prüfkontaktgruppen 21,22 fest angeordnet, von denen nur zwei zu sehen sind. Jede Prüfkontaktgruppe, wie 21,22, dient dem Kontaktieren einer Messerleiste, wie 23, oder einer Buchsenleiste, wie 24, die an einem jeweils mittels dieser Prüfeinrichtung 13 auf elektrische Fehlerfreiheit zu prüfenden Prüfling 25 angeordnet sind. Der dargestellte Prüfling 25 weist in diesem Ausführungsbeispiel eine Leiterplatte 27 auf, an deren Vorderseite eine Mehrzahl von Messerleisten, wie 23, und Buchsenleisten, wie 24, angeordnet sind, von denen nur je eine dargestellt ist.

Die einzelne Messerleiste 23 bzw. die einzelne Buchsenleiste 24 weist hier je zwei Reihen von Messern 29 bzw. nicht zu sehende Buchsen auf, wobei in jeder Reihe bspw. zweiunddreißig Messer 29 bzw. Buchsen in gleichen Abständen voneinander angeordnet sind. Die Messer- bzw. Buchsenleiste kann ggf. auch nur eine Reihe oder mehr als zwei Reihen von Messern bzw. Buchsen aufweisen, bspw. je drei Reihen. In derselben Konfiguration wie diese Messerleisten und Buchsenleisten 23,24 sind die ihrem Kontaktieren dienenden Prüfkontaktgruppen 21,22 an der Tragplatte 19 angeordnet. Diese Anordnung der Prüfkontaktgruppen 21,22 richtet sich also nach der Anordnung der zu kontaktierenden Messerleisten und Buchsenleisten am jeweiligen Prüfling. In der Regel werden eine große Anzahl gleicher Prüflinge durch die an der Tragplatte 19 angeordneten Prüfkontaktgruppen 21,22 nacheinander kontaktiert zwecks Prüfung der betreffenden Serie oder Serien von unter sich gleichen Prüflingen. Wenn die Ausbildung des Prüflings 25 wechselt, dann müssen solche Prüfkontaktgruppen 21,22 an der Tragplatte 19 oder einer anderen Tragplatte entsprechend für die anders ausgebildeten Prüflinge angeordnet werden. Diese Tragplatten 19 sind auswechselbar. Außer diesen Prüfkontaktgruppen 21,22, die dem Kontaktieren von Messerleisten und/oder Buchsenleisten 23,24 des jeweiligen Prüflings 25 dienen, können an der Tragplatte 19 noch weitere Prüfkontakte zum Kontaktieren anderer elektrischer oder elektronischer Teile oder Stellen, wie Leiterbahnen usw. der Prüflinge angeordnet sein, welche Prüfkontakte ebenfalls mit dem Testgerät 12 elektrisch verbunden sind.

Auf der Leiterplatte 27 des Prüflings 25, die diese Messerleisten und Buchsenleisten 23,24 trägt, können in nicht dargestellter Weise Leiterbahnen und sonstige elektrischen und elektronischen Teile zusätzlich vorgesehen sein.

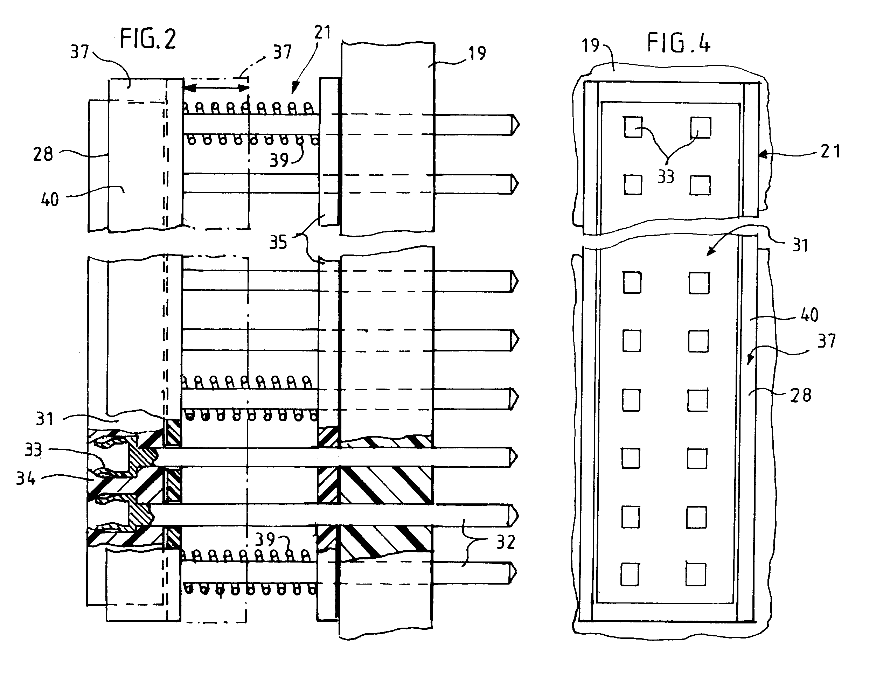

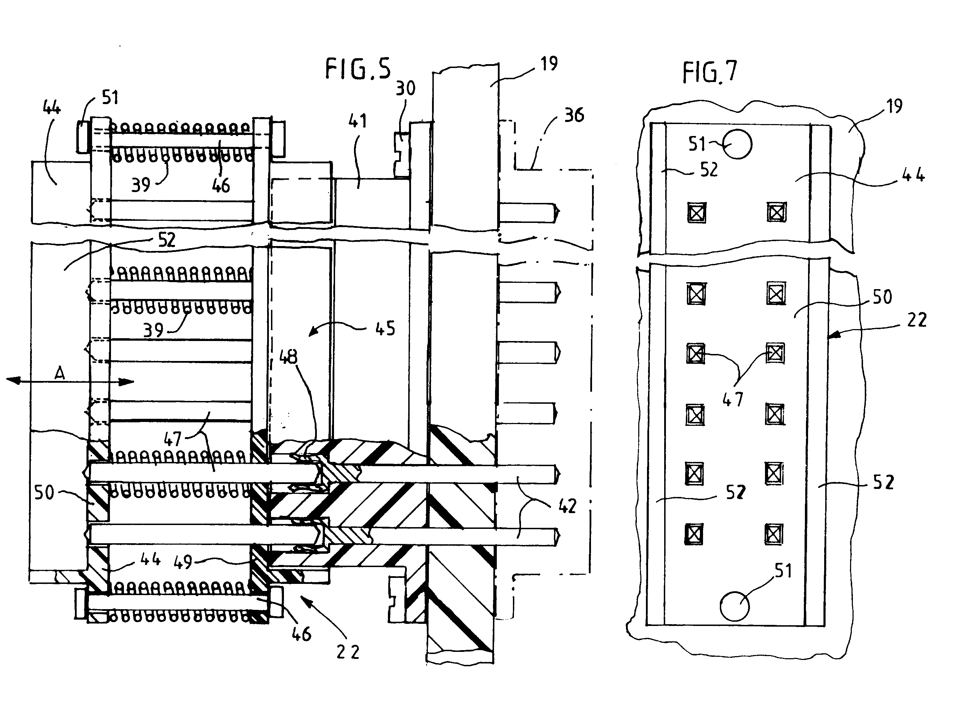

In den Fig. 2-4 ist die dem Kontaktieren jeweils aller Messer einer Messerleiste 23 eines Prüflinges dienende Prüfkontaktgruppe 21 der Fig. 1 näher dargestellt. Sie weist eine fest an der Tragplatte 19 mittels nur in Fig. 3 dargestellten Schrauben 30 lösbar befestigte Buchsenleiste 31 mit in ihrem Kunststoffteil 34 angeordneten, der Anzahl der Messer 29 des zu kontaktierenden Messerteiles 23 entsprechenden Anzahl von metallischen Buchsen 33 als Prüfkontakte auf. Anstelle der Buchsen können gewünschtenfalls auch andere Prüfkontakte vorgesehen sein, doch sind Buchsen hier besonders vorteilhaft. An jeder Buchse 33 ist ein gerader, wie ein Messer einer Messerleiste ausgebildeter metallischer Stift 32 fest angeordnet. Diese zueinander parallelen Stifte 32 stehen rückseitig über die Buchsenleiste 31 über und sind in einer von ihnen durchdrungenen Kunststoffplatte 35 befestigt, die mittels der Schrauben 30 auf der Tragplatte 19, an der sie vorderseitig anliegt, befestigt ist. Diese geraden Stifte 32 durchdringen Löcher der Tragplatte 19 und stehen über sie rückseitig über, wo auf sie zu ihrem elektrischen Anschluß eine Buchsenleiste 36 aufgesteckt ist, die über ein Kabel 11 mit dem Testgerät elektrisch verbunden ist. Diese Platte kann man auch als Trägerplatte bezeichnen.
Das Anschrauben der Platte 35 an die Tragplatte 19 kann auch unterlassen werden, wenn die Steckverbindungen der Stifte 32 mit der Buchsenleiste 36 der Platte 35 ausreichenden Halt geben, wobei mindestens zwei der Stifte 32 in der der Positionierung dieser Platte 35 dienende Löcher der Platte 19 formschlüssig eingesteckt sind. Und zwar ist dies dann möglich - und erlaubt besonders rasche und einfache Montage der Prüfkontaktgruppen 21,22, wenn, wie bevorzugt vorgesehen, beim Herstellen und Wiederlösen der Kontaktverbindungen zwischen den Prüfkontaktgruppen 21,22 und dem jeweiligen Prüfling 25 keine oder nur relativ geringe Zugkräfte auf die Prüfkontaktgruppen 21,22 vom Prüfling 25 ausgeübt werden.

Die Buchsenleiste 31 kann von handelsüblicher Art sein. Sie ist relativ zur Tragplatte 19 nicht beweglich. Auf den Bereichen der Stifte 32 zwischen der Platte 35 und dem Kunststoffteil 34 ist ein U-förmiges Druckteil 37 axial geradegeführt gelagert, das die Ausbildung wie das Kunststoffteil einer Messerleiste haben kann und für jeden Stift 32 ein Loch hat, die von den Stiften 32 zur Geradführung des Druckteiles 37 mit GLeitlagerspiel durchdrungen sind. Auf die Bereiche einiger Stifte 32 zwischen diesem Druckteil 37 und der Kunststoffplatte 35 sind Schraubendruckfedern 39 aufgesetzt, die sich an der Platte 35 an ihr ihre Widerlager habend abstützen und mit ihren vorderen Enden unter Vorspannung an der ebenen Rückseite des Druckteiles 37 anliegen. Dieses Druckteil 37 wird durch diese Rückstellfedern 39 an die Rückseite des Kunststoffteiles 34 angedrückt. Dieses Druckteil 37 hat zwei Längsseitenwände 40, die sich entlang den Längsseitenwänden des Kunststoffteiles 34 erstrecken und zu ihnen Gleitlagerspiel haben.

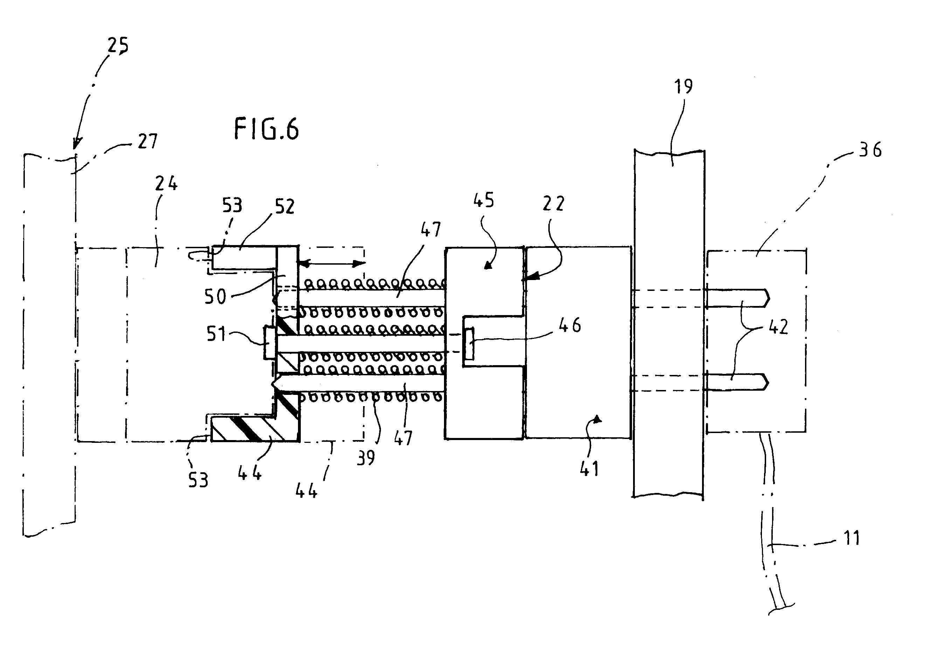

Diese Prüfkontaktgruppe 21 kann, da sie eine komplette Baueinheit für sich bildet, von der Tragplatte 19 abgeschraubt und an eine andere Tragplatte zum Prüfen anderer Prüflinge angeschraubt werden. Auch kann diese Prüfkontaktgruppe für sich hergestellt und vertrieben werden und von Käufern an Tragplatten in beliebiger Anordnung angebracht werden. Dasselbe gilt für die anderen Prüfkontaktgruppen 22 und 55, die in näheren Einzelheiten in den Fig. 5 bis 9 dargestellt sind.

Das Kunststoffteil der von der Prüfkontaktgruppe 21 zu kontaktierenden Messerleiste 23 weist zwei zueinander parallele Längsseitenwände 54 auf, die über die freien Enden der in ihnen befindlichen Messerbereiche überstehen und dem Inkontaktkommen mit den Kanten 28 der beiden Längsseitenwände 40 des Druckteiles 37 der Prüfkontaktgruppe 21 dienen, um dieses Druckteil 37 beim Herstellen der Steckverbindungen zwischen den Messern 29 der Messerleiste 23 des Prüflings 25 und den Buchsen der Buchsenleiste 31 der Prüfkontaktgruppe 21 gegen die Kraft der Rückstellfedern 39 in Richtung auf die Tragplatte 19 zu verschieben. Die von den Rückstellfedern 39 auf das Druckteil 37 ausgeübte Gesamtkraft ist dabei so groß, daß sie allein zum Lösen der Steckverbindungen zwischen den Messern 29 der Messerleiste 23 des Prüflings 25 und den Buchsen der Buchsenleiste 31 der Prüfkontaktgruppe 21 ausreicht, so daß diese Gesamtkraft dieser Federn 39 zumindest der gesamten Reibungskraft zwischen diesen Buchsen und Messern entspricht, die beim Lösen dieser Steckverbindungen auftritt und so zum Lösen dieser Steckverbindungen auf die Tragplatte 19 kein Zug ausgeübt werden muß.

Die in den Fig.5 bis 7 näher dargestellte Prüfkontaktgruppe 22 dient dem Kontaktieren aller Buchsen einer Buchsenleiste 24 des jeweiligen Prüflings 25. Diese Baueinheit 22 ist in eine an der Tragplatte 19 mittels Schrauben 30 (diese Schrauben 30 können auch hier unter den in Verbindung mit der vorstehenden Beschreibung der Fig. 2 bis 4 genannten Bedingungen ebenfalls entfallen, wenn nämlich die Steckverbindungen der Buchsenleisten 36 und 41 miteinander ausreichenden Halt an der Platte 19 geben) lösbar befestigte handelsübliche Buchsenleiste 41 lösbar eingesteckt, deren Messer bildende Anschlußstifte 42 Löcher der Tragplatte 19 durchdringen und über sie rückseitig überstehen und auf diese Anschlußstifte 42 ist eine mit dem Testgerät 12 elektrisch über ein Kabel 11 verbundene handelsübliche Buchsenleiste 36 aufgesteckt zum elektrischen Anschluß dieser Prüfkontaktgruppe 22 an das Testgerät 12. Die Prüfkontaktgruppe 22 weist eine Messerleiste 45, Rückstellfedern 39 und ein Druckteil 44 auf und ist durch zwei Führungs- und Haltestangen 46 zusammengehalten.

Die Messerleiste 45 kann handelsüblich sein und ihre Messer 47 sind in die Buchsen 48 der Buchsenleiste 41 zu ihrem elektrischen Anschluß eingesteckt. Diese Steckverbindungen reichen für den Halt der Prüfkontaktgruppe 22 auf der Messerleiste 45 infolge des Druckteiles 44 aus, da dieses verhindert, daß die Buchsenleiste 24 des Prüflings 25 auf die Prüfkontaktgruppe 22 Zug auszuüben vermag.

Die Messer 47 stehen in Richtung auf den jeweiligen Prüfling 25 weit über das Kunststoffteil 49 dieser Messerleiste 45 über und greifen mit Gleitlagerspiel in Bohrungen des Bodens 50 des Druckteils 44 ein, das wie das Kunststoffteil einer Messerleiste ausgebildet sein kann. Das U-förmigen Querschnitt aufweisende Druckteil 44 kann an eine zu kontaktierende Buchsenleiste 24 des Prüflings 25 ohne Kraftaufwendung bis zum Anliegen bewegt werden, da die Messer 47 nicht oder nur wenig über den Boden 50 überstehen, solange das Druckteil 44 durch die Rückstellfedern 39 an die Anschläge für es bildenden verbreiterten Köpfe 51 der Stangen 46 angedrückt sind. Diese Stangen 46 sind an dem Kunststoffteil 49 befestigt.

Auf einige der Messer 47 sind - an ihrer Stelle können gewünschtenfalls auch andere metallische Stifte vorgesehen sein - im Bereich zwischen dem Kunststoffteil 49 und dem Druckteil 44 Schraubendruckfedern 39 als Rückstellfedern aufgesteckt, desgleichen auf die beiden Stangen 46 an den Enden dieser Baueinheit 22.

Das U-förmigen Querschnitt aufweisende gerade Druckteil 44 weist zwei zueinander parallele Längsseitenwände 52 auf, die vom Boden 50 aus auf den Prüfling 25 zu gerichtet und dazu bestimmt sind, an je einen geraden stufenförmigen Absatz 53 an jeder Längsseitenwand des Kunststoffteiles einer durch diese Prüfkontaktgruppe zu kontaktierenden Buchsenleiste 24 am Prüfling 25 zur Anlage zu kommen, und zwar bevor die Messer 47 der Prüfkontaktgruppe 22 in die Buchsen der Buchsenleiste 24 am Prüfling 25 eindringen, und danach kann die Buchsenleiste 24 das Druckteil 44 anhalten, um es auf den Messern 47 horizontal bspw. bis in die strickpunktierte Stellung unter stärkerem Spannen der Federn 39 zu verschieben, wenn die Tragplatte 19 nach links bewegt wird, um die Messer 47 in die Buchsen der Buchsenleiste 24 einzuschieben. Oder es kann vorgesehen sein, daß die Stirnseite der Buchsenleiste 24 an den Boden 50 des Druckteiles 44 zu dessen Anhalten während der Weiterbewegung der Messer 47 gelangt.

Wenn die Tragplatte 19 mittels der Kolben-Zylinder-Einheit 18 in Fig. 1 nach links bewegt wird, dann gelangt das Druckteil 44 auf die zugeordnete Buchsenleiste 24 am Prüfling 25 und die beiden Längsseitenwände des Druckteiles bewegen sich mit geringem Gleitlagerspiel an den beiden Längsseitenwänden der Buchsenleiste 24 entlang bis sie zum Aufsitzen auf die stufenförmigen Absätze 53 kommen. Dies geht noch praktisch ohne Kraft vor sich, da die Messer 47 noch nicht in die Buchsen des Buchsenteiles eindringen. Nunmehr kann das Druckteil 44 jedoch nicht mehr weiterbewegt werden, wogegen die Tragplatte 19 durch die Kolben-Zylinder-Einheit 18 weiter in Richtung auf den Prüfling 25 zu bewegt wird und es dringen deshalb nunmehr die Messer 47 der Messerleiste 45 der Prüfkontaktgruppe 22 in die zugeordneten Buchsen der Buchsenleiste 24 ein und die Kolben-Zylinder-Einheit 18 führt diese Bewegung so weit durch, daß sicherer Kontakt zwischen den Messern 47 und den Buchsen erzielt wird, wie er in der Praxis ebenfalls auftritt, wenn man von Hand auf diese Buchsenleiste 24 eine Messerleiste aufstecken würde. Dabei werden diese Rückstellfedern 39 der Prüfkontaktgruppe 22 stärker gespannt, da sich der Abstand zwischen dem Druckteil 44 und dem Kunststoffteil 49 der Messerleiste 45 verringert. Die hierbei vorliegenden Federkräfte der Federn 39 sind nun so groß vorgesehen, daß auch diese Steckverbindungen des Buchsenteiles 24 des Prüflings 25 mit den Messern 47 der Prüfkontaktgruppe 22 von selbst allein durch die Federkraft der Rückstellfedern 39 dieser Prüfkontaktgruppe 22 gelöst werden, wenn die Kolben-Zylinder-Einheit 18 den Schlitten 16 und damit die Tragplatte 19 nach erfolgter Prüfung wieder nach rechts bewegt (Fig. 1). Parallel und gleichzeitig mit dem Herstellen und Wiederlösen der Steckverbindungen der Messer 47 mit der Buchsenleiste 24 durch die Kolben-Zylinder-Einheit 18 erfolgt auch das schon oben beschriebene Herstellen und Wiederlösen der Steckverbindungen zwischen den Messern 29 der Messerleiste 23 des Prüflings 25 und den Buchsen der Buchsenleiste 31 der Prüfkontaktgruppe 21, sowie aller weiteren nicht dargestellten Prüfkontaktgruppen 21, 22 mit den sonstigen Messerleisten bzw. Buchsenleisten, die am Prüfling 25 noch angeordnet sind. Für jede Messerleiste und Buchsenleiste am Prüfling ist an der Tragplatte 19 eine Baueinheit 21 bzw. 22 entsprechend angeordnet, so dass alle Messerleisten 23 und Buchsenleisten 24 eines Prüflings jeweils gleichzeitig durch die an der Tragplatte in entsprechender Konfiguration angeordneten Prüfkontaktgruppen 21, 22 kontaktiert werden können.

Das Druckteil 37 wird schon bei der Bewegung der Tragplatte 19 nach links durch die Messerleiste 23 angehalten, bevor durch das Weiterbewegen der Tragplatte die Messer 29 der Messerleiste 21 in die Buchsen 33 zur Herstellung der elektrischen Steckverbindungen der Prüfkontaktgruppe 21 eindringen. Die Federn 39 dieser Prüfkontaktgruppe 21 werden so stark gespannt, daß ihre Gesamtkraft ebenfalls das Wiederlösen dieser Steckverbindungen bewirkt, wenn die Kolben-Zylinder-Einheit 18 die Tragplatte 19 wieder nach rechts bewegt.

Diese Kontaktiervorrichtung 10 nach den Fig. 1 bis 9 ist baulich äußerst einfach, erlaubt sekundenschnelles Herstellen des elektrischen Anschlusses des jeweiligen Prüflinges 25 an das Testgerät 12 der Prüfeinrichtung 13 zur Durchführung der Prüfung und spart so erheblich Zeit. Auch ist sie kostengünstig. Die Prüfkontaktgruppen 21,22,55 können zumindest zum Teil aus handelsüblichen Kunststoffteilen, Messern und Buchsen zusammengesetzt sein und benötigen nur relativ geringen zusätzlichen baulichen Aufwand. Die Prüflinge 25 werden geschont, da auf sie beim Abziehen der Prüfkontakte keine Zugkräfte ausgeübt werden, sondern wie beim Herstellen der Steckverbindungen nur Druckkräfte. Die Leiterplatte 27 des jeweiligen Prüflings 25 ist zur Aufnahme dieser Druckkräfte an einer Vielzahl von Pfosten 20' der Haltevorrichtung 26 abgestützt.

Falls die Leiterplatte 27 oder der Verdrahtungsträger oder dgl. des Prüflings und die Tragplatte 19 auch horizontale Zugkräfte in gewissem Umfange aushalten können, kann man auch vorsehen, daß die Rückstellfedermittel 39 der Kontaktiervorrichtung 10 nicht die gesamten Kräfte zum Lösen der Steckverbindungen aufbringen, indem man die Rückstellfedern entsprechend schwächer ausbildet und/oder weniger Rückstellfedern vorsieht.

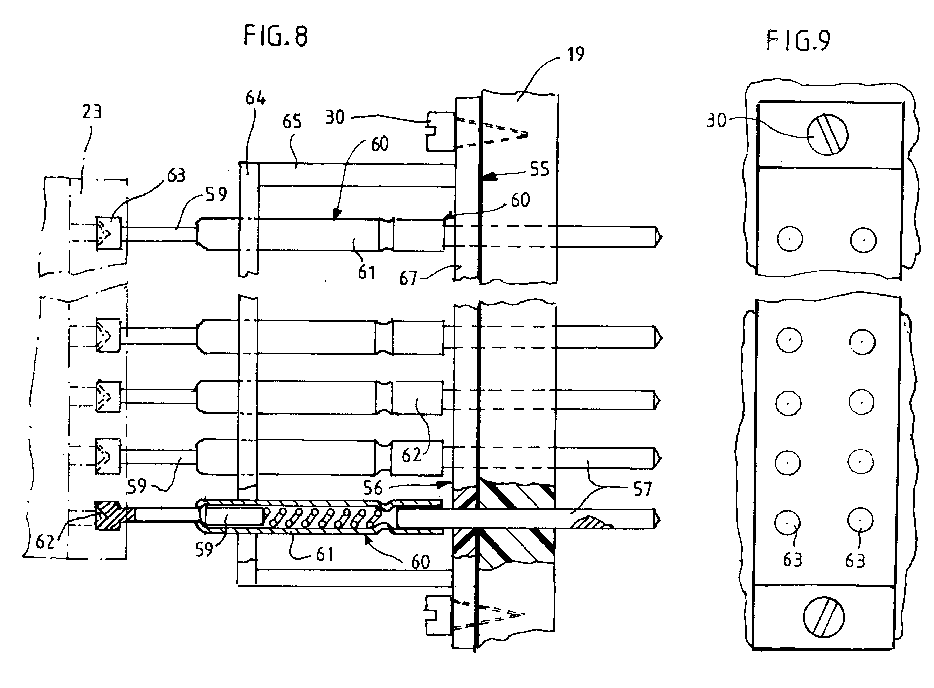

Während in den Ausführungsbeispielen nach den Fig. 2 bis 7 die Prüfkontakte, nämlich die Buchsen 33 und die Messer 47, ihre Abstände zur Tragplatte 19 nicht ändern können, ist in den Fig. 8 und 9 eine ebenfalls eine an die Platte 19 lösbar angeschraubte Baueinheit bildende Prüfkontaktgruppe 55 ,dargestellt, auf die dies nicht zutrifft. Diese Prüfkontaktgruppe 55, die dem Kontaktieren einer Messerleiste 23 des jeweiligen Prüflinges dient, weist eine vorzugsweise handelsübliche Messerleiste 56 oder eine Leiste (Stiftleiste) mit sonstigen zueinander parallelen, geraden metallischen Stiften auf, deren Kunststoffplatte 67 an der Tragplatte 19 anliegt und an sie mittels Schrauben 30 angeschraubt ist.Ihre in der Platte 67 fest angeordneten Messer 57 stehen rückseitig über diese Tragplatte 19 über, so daß auf sie hier eine Buchsenleiste (wie die Buchsenleisten 36 in Fig. 3 und 5 aufgesteckt werden kann, die über ein Kabel oder dgl. mit dem Testgerät der Prüfeinrichtung zu deren elektrischem Anschluß verbunden ist. Die Prüfkontakte dieser Prüfkontaktgruppe 55 sind hier durch die Kolbenglieder 59 von zueinander parallel angeordneten, gleich ausgebildeten Federkontaktstiften 60 gebildet.

Der Federkontaktstift 60 ist metallisch und weist eine Hülse 61 auf, die mit ihrem hinteren Endbereich 62 auf ein zugeordnetes Messer 57 oder Stift der Stiftleiste oder der Messerleiste 56 aufgesteckt und hierdurch in elektrischer Verbindung mit ihm reibungsschlüssig auf ihm gehalten wird. Diese Hülse 61 ist vorderseitig in einer Bohrung einer Platte 64 gehalten, die mittels Stützen 65 fest mit der zu ihr parallelen Platte 67 verbunden ist.

In der geraden Hülse 61 ist das Kolbenglied 59 gleitbar gelagert und steht über die Hülse in Richtung auf den jeweiligen Prüfling 25 vor und ist durch eine in der Hülse 61 angeordnete, vorgespannte, eine Rückstellfeder bildende Schraubendruckfeder 39 federbelastet. Der vordere Kopf 63 des Kolbengliedes 59 ist verbreitert und an seiner Stirnseite mit einer konischen Bohrung 62 versehen. Wenn eine solche, eine Baueinheit bildende Prüfkontaktgruppe 55 an der Trägerplatte 19 der Fig. 1 angeordnet ist, dann wird sie so angeordnet, daß die Köpfe 63 der Federkontaktstifte 60 alle Messer 29 einer Messerleiste 23 am Prüfling 25 gleichzeitig kontaktieren können, indem die Messer 29 in die konischen Vertiefungen 62 der freien Stirnenden der Kolbenglieder 59 eindringen und diese Kolbenglieder werden dann beim Weiterbewegen der Tragplatte 19 auf den jeweiligen Prüfling 25 zu durch die Messer 29 angehalten und dringen tiefer in die Hülsen 61 ein. Die Rückstellfedern 39 werden hierdurch stärker gespannt und üben auch gleichzeitig die für ein sicheres Kontaktieren der Messer 29 erforderlichen Kräfte auf die Kolbenglieder 59 aus. Bei der Prüfung eines Prüflinges 25 wird die Tragplatte 19 so weit nach links durch die Kolben-Zylinder-Einheit 18 verschoben, bis auch die Prüfkontakte 59 dieser Prüfkontaktgruppe 55 in sicheren elektrischen Kontakt mit den Messern der von ihr zu kontaktierenden Messerleiste 23 gelangt sind. Sie üben ebenfalls in keinem Stadium Zugkräfte auf die Prüflinge und die Tragplatte 19 aus.

Diese Federkontaktstifte 60 können an ihren vorderen Stirnenden auch so ausgebildet sein, daß sie dem Kontaktieren der Buchsen einer Buchsenleiste am Prüfling dienen. Bspw. können zu diesem Zweck die vorderen Endbereiche der Kolbenglieder der Federkontaktstifte wie die von Messern einer Messerleiste ausgebildet sein.

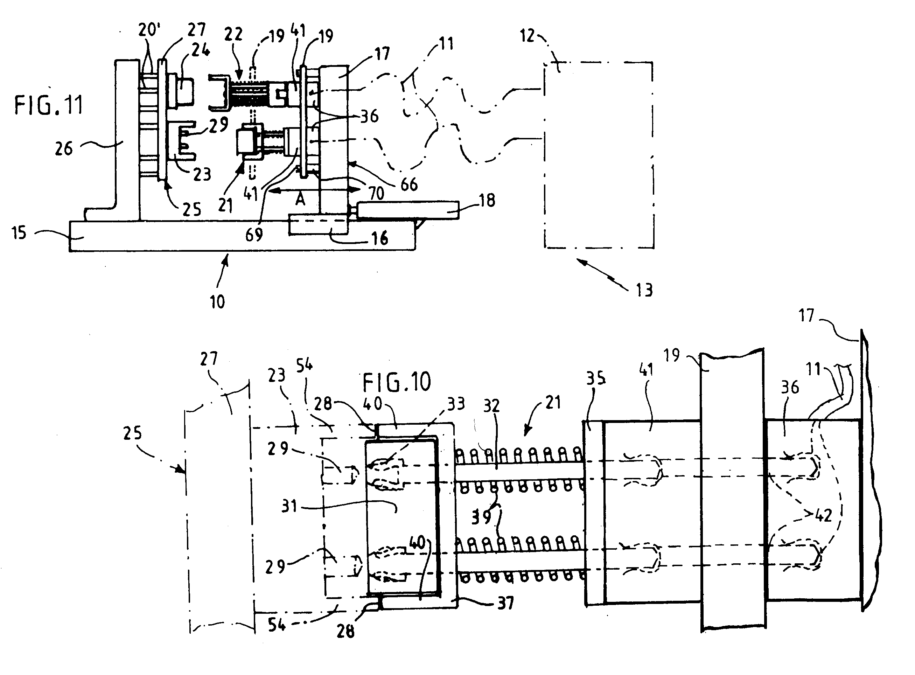

In vielen Fällen ist es besonders vorteilhaft, wenn eine Mehrzahl von Prüfkontaktgruppen, wie 21,22,55 oder auch andere Prüfkontaktgruppen, in bzw. auf der Tragplatte 19 oder mindestens einem sonstigen Träger oder sonstigen Tragmitteln angeordnete, ihrem elektrischen Anschluß dienende Anschlußteile, vorzugsweise Buchsenleisten, lösbar ein- oder aufsteckbar sind, wie es beim Ausführungsbeispiel nach den Fig. 5 bis 7 für die Prüfkontaktgruppe 22 der Fall ist, da diese in die an der Tragplatte 19 lösbar befestigte Buchsenleiste 41 einsteckbar ist. Diese Maßnahme ist in vielen Fällen auch für andere Prüfkontaktgruppen, vorzugsweise für alle Prüfkontaktgruppen der betreffenden Kontaktiervorrichtung bzw. des betreffenden Prüfadapters zweckmäßig, also bspw. auch für die Prüfkontaktgruppe 21, wie es in Fig. 10 dargestellt ist, indem an der Tragplatte 19 auf der der Platte 35 der Prüfkontaktgruppe 21 zugewendeten Seite ein deren elektrischem Anschluß und mechanischem Halten dienendes Anschlußteil angeordnet ist, vorzugsweise eine Buchsenleiste 41 (oder eine Messerleiste) gleich oder ähnlich der Buchsenleiste 41 des Ausführungsbeispieles nach den Fig. 5 bis 7, in die die entsprechend verkürzten Stifte 32 der Prüfkontaktgruppe 21 zum elektrischen und formschlüssigen und reibungsschlüssigen mechanischen Anschluß und Halten dieser Prüfkontaktgruppe 21 einsteckbar sind. Diese Buchsenleiste 41 wird hier genauso wie die Buchsenleiste 41 in Fig. 3 allein durch eine auf ihre Anschlußstifte 42 reibungsschlüssig und formschlüssig rückseitig der Platte 19 lösbar aufgesteckte Buchsenleiste 36 gehalten, an die ein zum Testgerät führendes Kabel 11 angeschlossen ist.

Vorzugsweise kann vorgesehen sein, daß für alle Prüfkontaktgruppen, wie 21,22,55 und ggf. auch noch andere oder sonstige Prüfkontaktgruppen an der Tragvorrichtung, vorzugsweise an einer Platte 19 oder einen sonstigen Träger oder mehreren Platten oder sonstigen Trägern, vorzugsweise unter sich gleich ausgebildete Anschlußteile, vorzugsweise Buchsenleisten 41 angeordnet sind, in die man dann Anschlußstifte der Prüfkontaktgruppen einsteckt, wenn diese Anschlußteile Buchsenleisten sind, oder, wenn diese Anschlußteile Messerleisten sind, werden dann die Prüfkontaktgruppen entsprechend mit an ihnen angeordneten Buchsen oder Buchsenleisten auf diese Messerleisten aufgesteckt. Bevorzugt kann dabei für jede Prüfkontaktgruppe je ein solches Anschlußteil, wie z.B. 41, an dem betreffenden mindestens einen Träger, der Platte 19 oder dgl. angeordnet sein. Dies hat den Vorteil, daß man beim Bestücken dieses mindestens einen Trägers, der Platte 19 oder dgl. mit diesen an ihr direkt angeordneten Anschlußteilen, wie Buchsenleisten 41 oder dgl., noch nicht darauf achten oder wissen muß, welcher Art die auf das jeweilige Anschlußteil später aufsteckbare Prüfkontaktgruppe sein muß, als bspw. noch nicht wissen muß, ob es sich um eine Prüfkontaktgruppe 21 oder 22 oder eine sonstige Prüfkontaktgruppe handelt, wenn, wie bevorzugt vorgesehen, für alle Prüfkontaktgruppen diese Anschlußteile unter sich gleich sind. Diese Anschlußteile können zweckmäßig ihrem elektrischen Anschluß dienende Stifte, wie 42, aufweisen, die eine Wand oder dgl., hier die Platte 19 durchdringen und auf die bevorzugt Buchsenleisten, wie 36, aufsteckbar sind, an denen Kabel 11 angeordnet sind, die ihrem elektrischen Anschluß an das Testgerät 12 dienen. Diese Anschlußteile 36 können so auf einfachste Weise die zugeordneten anderen Anschlußteile, wie 41, gleichzeitig am betreffenden Träger oder dgl., hier der Platte 19 mechanisch halten. In Fig. 11 ist auf diese Weise jede Prüfkontaktgruppe 21,22 an der Platte 19 mittels zusammengesteckten, an der Platte 19 anliegenden Buchsenleisten 36,41 gehalten.

Diese Fig. 11 zeigt noch eine weitere Abwandlung der Fig. 1. Und zwar ist in Fig. 1 die Tragplatte 19 an der Platte 17 der Tragvorrichtung 66 rückseitig mittels Pfosten 20 abgestützt. Es ist jedoch noch vorteilhafter, diese Abstützung durch alle oder einige der an der Platte 19 rückseitig anliegenden Anschlußteile, hier die Buchsenleisten 36, vorzunehmen, indem an ihnen die der Verbindung mit dem Testgerät 12 dienenden Kabel 11 nicht rückseitig, sondern seitlich angeordnet sind und man diese Anschlußteile, wie 36, mit ihren Rückseiten an der Platte 17 oder sonstigen Widerlagern zur Anlage kommen läßt, also hier die Platte 19 so anordnet, daß die Buchsenleisten 36 an der Platte 17 sich gegen vom jeweiligen Prüfling auf die Prüfkontaktgruppen 21,22 ausgeübten Druckkräfte abstützen. Es können dann die Pfosten 20 in Fig. 1 entfallen, wie es Fig. 11 zeigt. Es versteht sich, daß diese Tragplatte 19 dabei in geeigneter Weise lagezufixieren ist, bspw. mittels an ihr angeordneten und in die Platte 17 eingeschraubten Schrauben 69 und auf diese Schrauben aufgesteckte Distanzstücke 70. Man kann dann die Platte 19 jederzeit wieder abnehmen und sie gegen eine anders bestückte Platte 19 auswechseln. Diese Platte 19 mit den an ihr gehaltenen Prüfkontaktgruppen, wie 21,22, und Anschlußteilen, wie 41,36, kann man auch als Prüfadapter bezeichnen, der lösbar an Tragmitteln, hier der Platte 17 angebracht oder anbringbar ist.

Bei jeder einzelnen, dargestellten Prüfkontaktgruppe 21, 22 und 55 entspricht die Anzahl ihrer Prüfkontakte 33, 47 und 59 der der Buchsen oder Messer einer von ihr zu kontaktierenden Buchsenleiste 24 oder Messerleiste 23 eines Prüflings 25.

Man kann also die Tragplatte 19 zusammen mit den von ihr getragenen Teilen auch als Prüfadapter zum Prüfen von Prüflingen bezeichnen. Dieser Prüfadapter kann ggf. auch die Kontaktiervorrichtung oder ihre Tragvorrichtung allein bilden.

## Patentansprüche

1. Prüfeinrichtung (13) mit einer Kontaktiervorrichtung (10) und mindestens einem Prüfling (25), der eine Leiterplatte (27) und/oder einen Verdrahtungsträger aufweist, wobei die Kontaktiervorrichtung (10) mindestens eine Tragvorrichtung (66) mit Prüfkontakten (33, 47, 59) und Rückstellfedern (39) aufweist, **dadurch gekennzeichnet,** daß die Leiterplatte (27) und/oder der Verdrahtungsträger mit mehreren Messer- (23) und/oder Buchsenleisten (24) bestückt ist, daß die Prüfkontakte (33, 47, 59) beim Kontaktieren mit den Messer- (23) und/oder Buchsenleisten (24) Steckverbindungen bilden, und daß die Rückstellfedern (39) beim Kontaktieren der Prüfkontakte (33, 47, 59) mit den Messer- (23) und/oder Buchsenleisten (24) am Prüfling (25) direkt oder unter Zwischenschaltung eines beweglich gelagerten Druckteils (37, 44) zum Lösen oder zur Unterstützung des Lösens der Steckverbindungen angedrückt sind.

2. Prüfeinrichtung (13) nach Anspruch 1, **dadurch gekennzeichnet,** daß die Rückstellfedern (39) an den Prüfkontakten (33, 47, 59) angeordnet sind.

3. Prüfeinrichtung (13) nach einem der vorhergehenden Ansprüche, **dadurch gekennzeichnet,** daß die Tragvorrichtung (66) und/oder eine den jeweiligen Prüfling (25) haltende Haltevorrichtung (26) zum Kontaktieren des jeweiligen Prüflings (25) motorisch lageverstellbar ist.

4. Prüfeinrichtung (13) nach einem der vorhergehenden Ansprüche, **dadurch gekennzeichnet,** daß das Druckteil (37, 44) so ausgebildet ist, daß es an mindestens einem Vorsprung, Absatz oder einer Stirnfläche der betreffenden Messer- (23) und/oder Buchsenleiste (24) des Prüflings (25) zur Anlage kommt.

5. Prüfeinrichtung (13) nach einem der vorhergehenden Ansprüche, **dadurch gekennzeichnet,** daß mindestens einige der Prüfkontakte Starrstifte (37), vorzugsweise Messer (47) von Messerleisten (45), sind.

6. Prüfeinrichtung (13) nach einem der vorhergehenden Ansprüche, **dadurch gekennzeichnet,** daß mindestens einige Prüfkontakte Federkontaktstifte (60) sind.

7. Prüfeinrichtung (13) nach einem der vorhergehenden Ansprüche, **dadurch gekennzeichnet,** daß die Prüfkontakte Buchsen (33) mindestens einer Buchsenleiste (31) sind.

8. Prüfeinrichtung (13) nach Anspruch 7, **dadurch gekennzeichnet,** daß die Buchsenleiste (31) der Kontaktiervorrichtung an der Tragvorrichtung (66) angeordnet ist und Stifte (32) aufweist, auf denen das Druckteil (44) gleitbar gelagert ist, das durch auf mindestens einige der Stifte (32) aufgesteckte Rückstellfedern (39) in Richtung auf die Buchsenleiste (31) zu federbelastet ist.

9. Prüfeinrichtung (13) nach einem der vorhergehenden Ansprüche, **dadurch gekennzeichnet,** daß mindestens eine der Rückstellfedern (39) eine Druckfeder, vorzugsweise Schraubenfeder, ist.

10. Prüfeinrichtung (13) nach einem der vorhergehenden Ansprüche, **dadurch gekennzeichnet,** daß die Prüfkontakte Messer (47) einer mit der Tragvorrichtung (66) der Kontaktiervorrichtung fest verbundenen Messerleiste (45) sind, daß auf den Messern (47) das Druckteil (44) gleitbar angeordnet ist, und daß auf mindestens einigen Messern (47) Schraubenfedern als Rückstellfedern (39) aufgesteckt sind.

11. Prüfeinrichtung (13) nach einem der vorhergehenden Ansprüche, **dadurch gekennzeichnet,** daß die Prüfkontakte an einem Träger oder einer Platte (19) angeordnet sind, die lösbar an der Tragvorrichtung (66) anbringbar ist oder sie bildet.

12. Prüfeinrichtung (13) nach Anspruch 11, **dadurch gekennzeichnet,** daß an der dem Prüfling zugewendeten Vorderseite des Trägers oder der Platte (19) mindestens ein Anschlußteil (41), vorzugsweise mindestens eine Buchsenleiste und/oder Messerleiste zum Anschluß von Prüfkontakten, angeordnet ist, die an dieses Anschlußteil (41) lösbar ansteckbar sind beziehungsweise ist, wobei vorzugsweise dieses Anschlußteil (41) rückseitig Stifte aufweist, die seinem elektrischen Anschluß dienen.

13. Prüfeinrichtung (13) nach Anspruch 12, **dadurch gekennzeichnet,** daß das Anschlußteil (41) dadurch am Träger (19) gehalten ist, indem es den Träger (19) durchdringende Anschlußstifte (42) aufweist, auf die rückseitig ein dem elektrischen Anschluß dienendes anderes Anschlußteil, vorzugsweise eine Buchsenleiste (36), aufgesteckt ist, welches vorzugsweise auch dem lösbaren Halten des anderen Anschlußteils (41) dient.

## Claims

1. Testing unit (13) with a contacting device (10) and at least one testpiece (25) which has a circuit board (27) and/or a wiring carrier, the contacting device (10) having at least one carrier device (66) with test contacts (33, 47, 59) and return springs (39), characterised in that the circuit board (27) and/or the wiring carrier is equipped with several blade contact strips (23) and/or socket contact strips (24), that the test contacts (33, 47, 59) form plug connections on contact with the blade contact strips (23) and/or socket contact strips (24), and that when the test contacts (33, 47, 59) contact the blade socket strips (23) and/or socket contact strips (24) on the testpiece (25) the return springs (39) are pressed directly or through the intermediary of a movably mounted pressure piece (37, 44) so as to release or to aid the release of the plug connections.

2. Testing unit (13) according to Claim 1, characterised in that the return springs (39) are arranged on the test contacts (33, 47, 59).

3. Testing unit (13) according to one of the preceding claims, characterised in that the carrier device (66) and/or a holding device (26) which holds the particular testpiece (25) can be adjusted in position by motorised means in order to contact the particular testpiece (25).

4. Testing unit (13) according to one of the preceding claims, characterised in that the pressure part (37, 44) is constructed so that it comes to rest on at least one projection, step or end face of the relevant blade contact strip (23) and/or socket contact strip (24) of the testpiece (25).

5. Testing unit (13) according to one of the preceding claims, characterised in that at least some of the test contacts are rigid pins (37), preferably blade contacts (47) of blade contact strips (45).

6. Testing unit (13) according to one of the preceding claims, characterised in that at least come test contacts are spring contact pins (60).

7. Testing unit (13) according to one of the preceding claims, characterised in that the test contacts are socket contacts (33) of at least one socket contact strip (31).

8. Testing unit (13) according to Claim 7, characterised in that the socket contact strip (31) of the contacting device is arranged on the carrier device (66) and has pins (32) on which the pressure part (37) is slidably mounted, this pressure part being spring loaded in the direction of the socket contact strip (31) by return springs (39) fitted on at least some of the pins (32).

9. Testing unit (13) according to one of the preceding claims, characterised in that at least one of the return springs (39) is a pressure spring, preferably a helical spring.

10. Testing unit (13) according to one of the preceding claims, characterised in that the test contacts are blade contacts (47) of a blade contact strip (45) which is fixed to the carrier device (66) of the contacting device, that the pressure part (44) is slidably arranged on the blade contacts (47), and that helical springs are fitted as return springs (39) onto at least some blade contacts (47).

11. Testing unit (13) according to one of the preceding claims, characterised in that the test contacts are arranged on a carrier or a board (19) which can be releasably attached to the carrier device (66) or forms the carrier device.

12. Testing unit (13) according to Claim 11, characterised in that at least one terminal part (41), preferably at least one socket contact strip and/or blade contact strip, is or are arranged on the front face of the carrier or the board (19) facing the testpiece for the connection of test contacts and is or are releasably attachable to this terminal part (41), this terminal part (41) preferably having on its rear face pins which serve for its electrical connection.

13. Testing unit (13) according to Claim 12, characterised in that the terminal part (41) is hold on the carrier (19) by means of its terminal pins (42) which pass through the carrier (19), and another terminal part, preferably a socket contact strip (36), which serves for electrical connection is fitted onto the said terminal pins at the rear and also preferably serves to hold the other terminal part (41) releasably.

## Revendications

1. Dispositif testeur (13) avec un contacteur (10) et au moins un échantillon à tester (25), qui présente une plaquette imprimée (27) et/ou un élément porteur de câblage, le contacteur (10) présentant au moins un dispositif porteur (66) avec des contacts de test (33, 47, 59) et des ressorts de rappel (39), **caractérisé** en ce que la plaquette imprimée (27) et/ou l'élément porteur de câblage est équipée(e) de plusieurs réglettes à couteaux (23) et/ou à douilles (24), en ce que les contacts de test (33, 47, 59) forment des connexions enfichées lors de leur mise en contact avec les réglettes à couteaux (23) et/ou à douilles (24), et en ce que, lors de la mise en contact des contacts de test (33, 47, 59) avec les réglettes à couteaux (23) et/ou à douilles (24), les ressorts de rappel (39) sont pressés contre l'échantillon (25) directement ou avec intercalation d'une pièce de pression (37, 44) montée à déplacement, en vue de supprimer ou d'assister la suppression des connexions enfichées.

2. Dispositif testeur (13) selon la revendication 1, **caractérisé** en ce que les ressorts de rappel (39) sont disposés sur les contacts de test (33, 47, 59).

3. Dispositif testeur (13) selon l'une quelconque des revendications précédentes, **caractérisé** en ce que le dispositif porteur (66), et/ou un dispositif de fixation (26) maintenant l'échantillon respectif (25), peut être déplacé de manière motorisée pour la mise en contact de l'échantillon respectif (25).

4. Dispositif testeur (13) selon l'une quelconque des revendications précédentes, **caractérisé** en ce que la pièce de pression (37, 44) est configurée de telle sorte qu'elle vient s'appliquer contre au moins une saillie, un appendice ou une face frontale des réglettes à couteaux (23) et/ou à douilles (24) concernées de l'échantillon (25).

5. Dispositif testeur (13) selon l'une quelconque des revendications précédentes, **caractérisé** en ce qu'au moins quelques-uns des contacts de test sont des broches rigides (37), de préférence des couteaux (47) de réglettes à couteaux (45).

6. Dispositif testeur (13) selon l'une quelconque des revendications précédentes, **caractérisé** en ce qu'au moins quelques contacts de test sont des broches de contact à ressort (60).

7. Dispositif testeur (13) selon l'une quelconque des revendications précédentes, **caractérisé** en ce que les contacts de test sont des douilles (33) d'au moins une réglette à douilles (31).

8. Dispositif testeur (13) selon la revendication 7, **caractérisé** en ce que la réglette à douilles (31) du contacteur est disposée sur le dispositif porteur (66) et présente des broches (32) sur lesquelles est montée à coulissement la pièce de pression (37), qui est sollicitée élastiquement en direction de la réglette à douilles (31) par des ressorts de rappel (49) enfilés sur au moins quelques-unes des broches (32).

9. Dispositif testeur (13) selon l'une quelconque des revendications précédentes, **caractérisé** en ce qu'au moins un des ressorts de rappel (39) est un ressort de pression, de préférence un ressort hélicoïdal.

10. Dispositif testeur (13) selon l'une quelconque des revendications précédentes, **caractérisé** en ce que les contacts de test sont des couteaux (47) d'une réglette à couteaux (45) rigidement assemblée au dispositif porteur (66) du contacteur, en ce que la pièce de pression (44) est montée à coulissement sur les couteaux (47), et en ce que des ressorts hélicoïdaux sont enfilés comme ressorts de rappel (39) sur au moins quelques couteaux (47).

11. Dispositif testeur (13) selon l'une quelconque des revendications précédentes, **caractérisé** en ce que les contacts de test sont disposés sur un élément porteur ou une plaque (19), qui peut être fixée de manière amovible sur le dispositif porteur (66) ou qui le constitue.

12. Dispositif testeur (13) selon la revendication 11, **caractérisé** en ce qu'est disposée, sur le côté avant, tourné vers l'échantillon, de l'élément porteur ou de la plaque (19), au moins une pièce de raccordement (41), de préférence au moins une réglette à douilles et/ou une réglette à couteaux pour le raccordement de contacts de test qui peuvent être enfichés de manière amovible sur cette pièce de raccordement (41), cette pièce de raccordement (41) présentant de préférence, sur le côté arrière, des broches servant à son raccordement électrique.

13. Dispositif testeur (13) selon la revendication 12, **caractérisé** en ce que la pièce de raccordement (41) est maintenue sur l'élément porteur (19) par le fait qu'elle présente des broches de raccordement (42), qui traversent l'élément porteur (19) et sur lesquelles est enfichée, sur le côté arrière, une autre pièce de raccordement servant au raccordement électrique, de préférence une réglette à douilles (36), qui sert de préférence également au maintien amovible de l'autre pièce de raccordement (41).
